Europäisches Patentamt

European Patent Office

Office européen des brevets

(11) Publication number: **0 167 281 B1**

# EUROPEAN PATENT SPECIFICATION

(45) Date of publication of patent specification: **03.02.93**   (51) Int. Cl.⁵: **G11C 5/06**, G11C 11/404

(21) Application number: **85303868.5**

(22) Date of filing: **31.05.85**

(54) Semiconductor memory device.

(30) Priority: **31.05.84 JP 109474/84**

(43) Date of publication of application:
**08.01.86 Bulletin 86/02**

(45) Publication of the grant of the patent:
**03.02.93 Bulletin 93/05**

(84) Designated Contracting States:
**DE FR GB**

(56) References cited:
**US-A- 3 942 164**

(73) Proprietor: **FUJITSU LIMITED**
**1015, Kamikodanaka Nakahara-ku**
**Kawasaki-shi Kanagawa 211(JP)**

(72) Inventor: **Takemae, Yoshihiro**
**8-13-24-303, Akasaka**
**Minato-ku Tokyo 107(JP)**

(74) Representative: **Sunderland, James Harry et al**
**HASELTINE LAKE & CO Hazlitt House 28**
**Southampton Buildings Chancery Lane**
**London WC2A 1AT(GB)**

**Description**

The present invention relates to a semiconductor memory device, more particularly to a semiconductor memory device having bit line pairs, such as a one-transistor one-capacitor dynamic memory, wherein a reduction in the amount of the read charges due to the capacitance between bit lines is prevented by a special arrangement of the bit lines.

The dimensions of the memory cells included in semiconductor memory devices are becoming smaller every year. Along with this, the distance between bit lines has also become smaller. For this reason, the parasitic capacitance between bit lines has become larger. As a result, the noise due to changes in potential of an adjacent bit line has come to have an appreciable effect on the potential of a selected bit line, leading to the phenomena of read errors in data.

US-A-3 942 164 discloses a semiconductor memory device according to the preamble of accompanying claim 1. This device is a static-type device employing binary circuits such as flip-flops as the memory cells. The bit lines are intersected to reduce capacitive coupling and thereby reduce large transient currents appearing on the bit lines.

According to the present invention, there is provided a semiconductor memory device comprising a semiconductor memory device comprising:-

a plurality of word lines;

a plurality of bit line pairs, each comprised of two adjacently arranged bit lines;

a plurality of memory cells connected between the word lines and bit lines; and

a plurality of sense circuits, each connected to one of said bit line pairs;

wherein the bit lines of at least every other pair of said bit line pairs are made to intersect at at least one portion thereof;

characterised in that:-

the device is a dynamic semiconductor memory device in which the memory cells are one-transistor one-capacitor type memory cells each connected between one of said bit lines and one of said word lines, and in each of said bit line pairs, the memory cells are connected between each one of said word lines and either one of the two bit lines of each bit line pair; wherein said sense circuits are in the form of sense amplifiers, each of said sense amplifiers amplifying the voltage difference between the bit lines of the corresponding bit line pair to which it is connected; and wherein in a precharging operation, each of the bit line pairs is precharged at a voltage which is an intermediate level relative to a power source voltage level, and in a sensing operation, the capacitor of the memory cell selected by the word line is connected, via the transistor, to one of the two bit lines which comprises the bit line pair, and after the output of the selected memory cell has appeared on said one of the bit lines, the difference voltage between said bit line and the other bit line is amplified by the corresponding sense amplifier.

An embodiment of the present invention can provide a dynamic semiconductor memory device having bit line pairs wherein the noise due to changes in potential of an adjacent bit line pair is reduce and, thereby, read errors are prevented.

Reference is made, by way of example, to the accompanying drawings, in which :-

Fig. 1 is a circuit diagram of an arrangement of bit line pairs in a conventional one-transistor one-capacitor dynamic memory;

Figs. 2A and 2B are waveform diagrams for explaining the memory operation of the circuit of Fig. 1 in the case where the capacitance between bit lines is ignored;

Figs. 3A and 3B are waveform diagrams for the memory operation in the circuit of Fig. 1 in the case where consideration is given to the capacitance between bit lines;

Fig. 4 is a plan view showing the physical construction of part of the circuit of Fig. 1;

Fig. 5 is a cross-sectional view of Fig. 4 along the line V-V ;

Fig. 6 is a circuit diagram showing the arrangement of bit line pairs in a one-transistor one-capacitor dynamic memory according to an embodiment of the present invention;

Figs. 7A and 7B are waveform diagrams for explaining the memory operation of the circuit of Fig. 6;

Fig. 8 is a circuit diagram showing another embodiment of the present invention;

Fig. 9 is a circuit diagram showing still an other embodiment of the present invention;

Fig. 10 is a plan view showing the physical construction of part of the circuit of Fig. 6; and

Fig. 11 is a cross-sectional view of Fig. 10 along the line XI - XI.

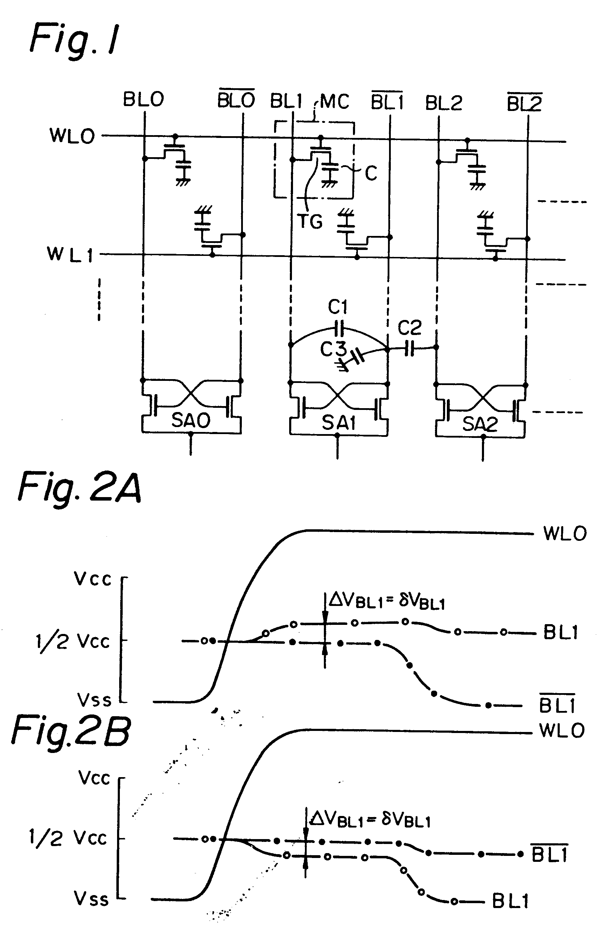

Figure 1 is a circuit diagram showing an arrangement of bit line pairs in a conventional one-transistor one-capacitor dynamic memory. In Fig. 1, a plurality of bit line pairs (BL0, $\overline{\text{BL0}}$), (BL1, $\overline{\text{BL1}}$), (BL2, $\overline{\text{BL2}}$), ... run in parallel. The ends of each bit line pair are connected to sense amplifiers SA0, SA1, SA2, ... Intersecting the bit line pairs are the word lines WL0, WL1, ... which also run in parallel. Between the word line WL0 and the bit lines BL0, BL1, BL2, ... are connected memory cells MC. Each of the memory cells MC consists of a single transfer gate transistor TG and a data storage type capacitor C. Between the word line WL1 and the bit lines BL0, BL1, BL2, ... are also connected identical memory cells MC. Other word lines and bit lines (not shown) also have memory cells MC connected between them.

As explained above, when the distance between bit lines becomes narrower, the parasitic capacitance between the bit lines has an appreciable effect on a data read operation. In the figure, the capacitance C1 between the bit lines BL1 and $\overline{BL1}$ and the capacitance C2 between the bit lines $\overline{BL1}$ and BL2 are shown by way of example. C3 is the parasitic capacitance between the bit line $\overline{BL1}$ and the ground. The opposing electrodes of the capacitors C are also connected to the ground.

Figures 2A and 2B are waveform diagrams for explaining the memory operation of the circuit of Fig. 1 in the case where the capacitance C1 and C2 between bit lines is ignored.

Figure 2A is a graph in the case of storage of a charge in the capacitor C in a memory cell connected between the bit line BL1 and word line WL0. In this case, if the word line WL0 is selected and raised to a level higher than the power supply voltage $V_{CC}$ , when the transfer gate transistor TG reaches an "on" state, the charge stored in the capacitor C discharges to the bit line BL1, and, as a result, the potential of the bit line BL1, which had been precharged to 1/2 $V_{CC}$ , rises by $\delta V_{BL1}$. On the other hand, the potential of the bit line $\overline{BL1}$, if the capacitance between the bit lines is ignored, remains at the precharged voltage of 1/2 $V_{CC}$. Therefore, the potential difference $\Delta V_{BL1}$ between the bit lines BL1, $\overline{BL1}$ equals the potential rise $V_{BL1}$ of the bit line BL1. The potential difference between the bit lines BL1, $\overline{BL1}$ is amplified by the sense amplifier SA1, resulting in readout of data "1" in the capacitor C.

Figure 2B is a graph for explaining the memory operation in the case where no charge is stored in the above-mentioned capacitor C. In this case, selection of the word line WL0 leads to an influx of the charge of the bit line BL1 to the capacitor C, so the potential of the bit line BL1 falls by $\delta V_{BL1}$ from 1/2 $V_{CC}$ , while the potential of the bit line $\overline{BL1}$, if the capacitance between bit lines is ignored, remains at 1/2 $V_{CC}$. Therefore, the potential difference $\Delta V_{BL1}$ between the bit lines BL1, $\overline{BL1}$ equals the potential drop $\delta V_{BL1}$ of the bit line BL1. The potential difference between the bit lines BL1, $\overline{BL1}$ is also amplified by the sense amplifier SA1, resulting in readout of data "0" in the capacitor C.

The above-mentioned potential rise or potential drop $\delta V_{BL1}$ is determined by the following equation (1):

$$\delta V_{BL1} \simeq \frac{C_S}{C_3} \times \frac{1}{2} V_{CC} \qquad (1)$$

where, $C_S$ is the cell capacitance of a memory cell MC, and $C_3$ is the capacitance between the bit line $\overline{BL1}$ and the ground. For the sense amplifier SA1 to be able to detect the potential difference between bit lines, $\delta V_{BL1}$ must be at least 100 mV.

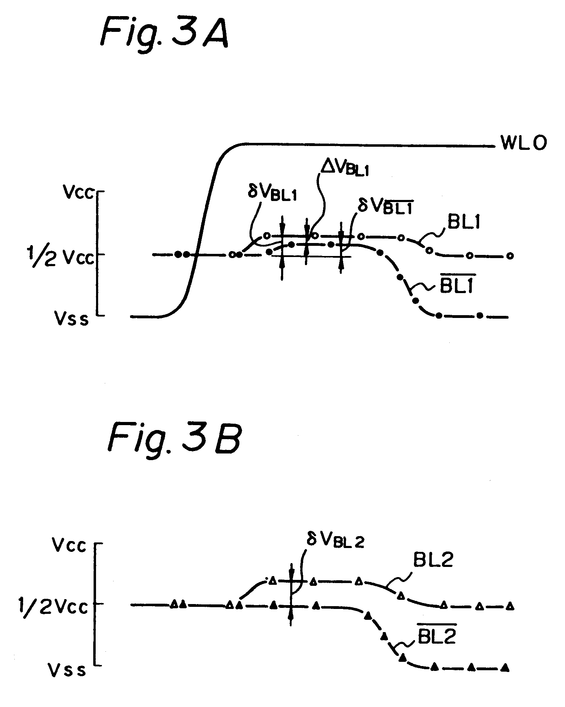

Figures 3A and 3B are waveform diagrams for explaining the problems in a memory operation in the circuit of Fig. 1 in the case where consideration is given to the parasitic capacitances C1, C2, and C3. Figure 3A shows the changes in potential of the bit lines BL1, $\overline{BL1}$ in the case where the above-mentioned capacitor C in the memory cell MC stores a charge. Figure 3B shows the changes in potential of adjacent bit lines BL2, $\overline{BL2}$.

In Fig. 3A, if the word line WL0 is selected, the potential of the bit Line BL1 rises by $\delta V_{BL1}$ , just as in the case of Fig. 2A. However, the potential of the bit line $\overline{BL1}$ also is affected by the potential rise of the adjacent bit lines BL1 and BL2 via the parasitic capacitances C1 and C2 and thus rises from the precharged voltage 1/2 $V_{CC}$ by $\delta V_{\overline{BL1}}$. The potential of the adjacent bit line BL2 rises by $\delta V_{BL2}$ as shown in Fig. 3B through selection of the word line WL0 when a charge is stored in the memory cell connected between the bit line BL2 and the word line WL0 - just as in the case of the potential rise of the bit line BL1. The potential rise $\delta V_{\overline{BL1}}$ of the bit line $\overline{BL1}$ can be approximated by the following equation (2):

$$\delta V_{\overline{BL1}} \simeq \frac{C_1}{C_1 + C_2 + C_3} \delta V_{BL1} + \frac{C_2}{C_1 + C_2 + C_3} \delta V_{BL2} \qquad (2)$$

In equation (2), the first member on the right indicates the effect of the potential rise of the bit line BL1 to the bit line $\overline{BL1}$, and the second member on the right indicates the effect of the potential rise of the bit line BL2 to the bit line $\overline{BL1}$. In equation (2), if the approximation that C1 = C2 = C3 and $\delta V_{BL1}$ = $\delta V_{BL2}$ is made, then

$$\delta V_{\overline{BL1}} \simeq \tfrac{2}{3} \delta V_{BL1} \qquad (3)$$

Therefore, the potential difference $\Delta V_{BL1}$ between the bit lines BL1, $\overline{BL1}$ is:

$$\Delta V_{BL1} = \delta V_{BL1} - \delta V_{\overline{BL1}} \simeq \tfrac{1}{3} \delta V_{BL1} \qquad (4)$$

and falls to 1/3 that in the case of normal operation. If the potential difference between the bit lines BL1, $\overline{BL1}$ becomes smaller in this way, the sense amplifier SA1 cannot detect the potential difference and read errors will occur.

In the above-described calculations with reference to Figs. 3A and 3B, the effects of the bit line $\overline{BL1}$ on the bit line BL1 or the bit line BL2 are ignored for the sake of simplicity. In practice, the bit lines BL1 and $\overline{BL1}$ and the bit lines $\overline{BL1}$ and BL2 have mutual effects on each other. These effects can be calculated by computer simulation. The results of the simulation, however, would be approximately the same as the above calculations expressed by the equations (2), (3) and (4).

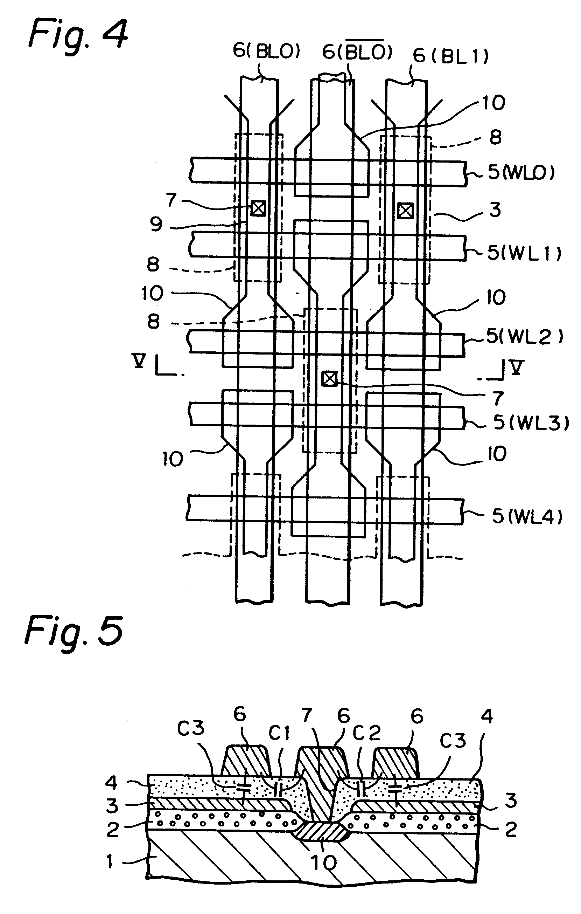

Figure 4 is a plan view showing the physical construction of part of the circuit of Fig. 1. Figure 5 is a cross-sectional view of Fig. 4 along the line V-V. In Fig. 4 and Fig. 5, 1 indicates a semiconductor substrate, 2 a field oxide layer of $SiO_2$ , 3 a first polycrystalline silicon layer to be grounded for one electrode of the capacitor C comprising the memory cell MC, 4 an insulation film of phosphosilicate glass (PSG), 5 a second polycrystalline silicon layer for forming word lines WL0, WL1, WL2, ... , 6 an aluminum layer for forming bit lines BL0, $\overline{BL0}$, BL1, $\overline{BL1}$, ... , 7 a contact hole, the portion 8 surrounded by dotted lines, a window for bringing a bit line 6 into contact with an impurity diffused layer 9, and 10 an active region in which a memory cell MC is formed.

As shown in Fig. 5, since the distance between bit lines 6 has become narrower, the static capacitances C1, C2 between the same become a problem. The static capacitance C3, formed between the bit lines 6 and the first polycrystalline silicon layer 3, also is a problem.

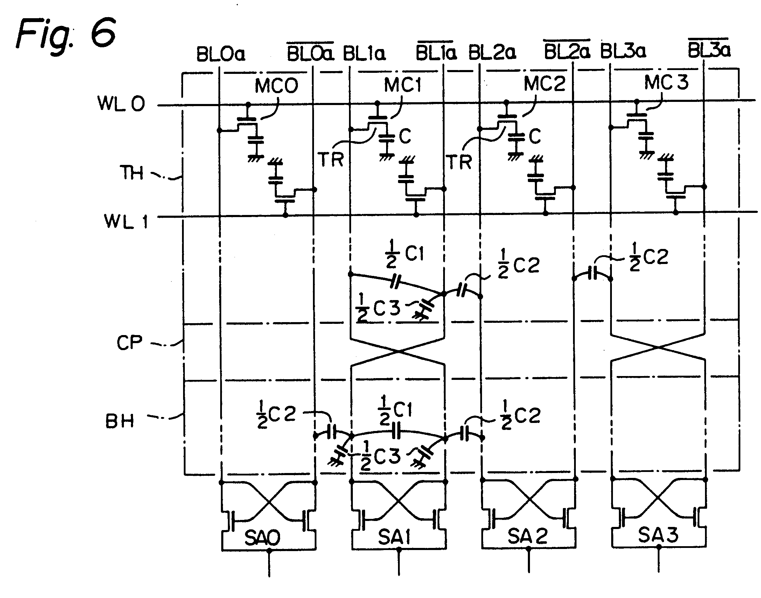

Figure 6 is a circuit diagram of the arrangement of bit line pairs in a one-transistor one-capacitor dynamic memory according to an embodiment of the present invention. In Fig. 6, portions the same as in the prior art example of Fig. 1 are given the same reference characters. The difference with Fig. 1 is that the two bit lines forming each of every other bit line pairs (BL1a, $\overline{BL1a}$), (BL3a, $\overline{BL3a}$), ... intersect at a midway portion CP (center portion in the figure). With the exception of this intersecting portion, the bit lines run in parallel. This construction means that, for example, for the bit line $\overline{BL1a}$, in the illustrated top half TH from the center portion CP, the static capacitance with the adjacent bit line BL1a becomes 1/2 C1, the static capacitance with the adjacent bit line BL2a becomes 1/2 C2, and the parasitic capacitance with the ground becomes 1/2 C3. Further, in the illustrated bottom half BH from the center portion CP, the static capacitance with the adjacent bit line BL1a becomes 1/2 C1, the static capacitance with the adjacent bit line $\overline{BL0a}$ becomes 1/2 C2, and the static capacitance with the ground becomes 1/2 C3. Since the bit line $\overline{BL1a}$ and the bit line BL2a are distant from each other in the bottom half BH, the static capacitance between them can be ignored. The total capacitance given to the bit line $\overline{BL1a}$ can thus be approximated as C1 + C2 + C3 as in the prior art example.

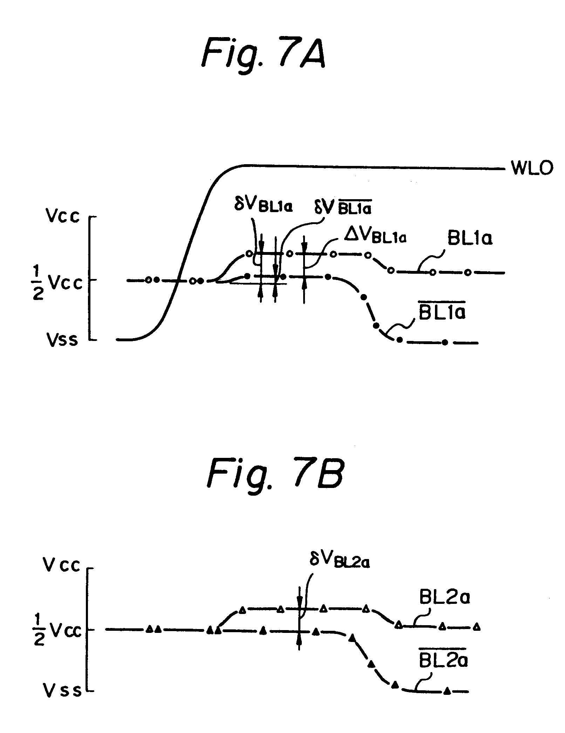

Figures 7A and 7B are waveform diagrams for explaining the memory operation of the circuit of Fig. 6. Figure 7A shows the changes in potential of the bit lines BL1a, $\overline{BL1a}$ in the case of charges stored in the memory cells MC1 and MC2 connected between the word line WL0 and the bit line BL1a. Figure 7B shows the changes in potential of bit lines BL2a, $\overline{BL2a}$ in the case of a charge stored in the memory cell MC2 connected between the word line WL0 and the bit line BL2a.

If the word line WL0 is selected, the potential of the bit line BL2a is increased by the rise $\delta V_{BL2a}$ due to the influx of the charge from the memory cell MC2. Also, if the word line WL0 is selected, as shown in Fig. 7A, the potential of the bit line BL1a is increased, first, by the rise $\delta V_{BL1}$ due to the influx of the charge from the memory cell MC1 and, second, by the potential rise of the adjacent bit line BL2a in the illustrated bottom half BH from the center portion CP via the static capacitance 1/2 C2. As a result, the potential rise $\delta V_{BL1a}$ of the bit line BL1a is approximated as:

$$\delta V_{BL1a} \simeq \delta V_{BL1} + \frac{1/2 \ C_2}{C_1 + C_2 + C_3} \delta V_{BL2a} \qquad (5)$$

On the other hand, the potential rise $\delta V_{\overline{BL1a}}$ of the bit line $\overline{BL1a}$ is approximated by the following equation:

$$\delta V_{\overline{BL1a}} \simeq \frac{C_1}{C_1 + C_2 + C_3} \delta V_{BL1a}$$

$$+ \frac{1/2 \ C_2}{C_1 + C_2 + C_3} \delta V_{BL2a} \qquad (6)$$

In equation (6), the first member on the right indicates the effect of the potential rise of the bit line BL1a on the bit line $\overline{BL1a}$. In more detail, at the top half TH, the potential of the bit line $\overline{BL1a}$ is raised by

$$\frac{1/2 \ C1}{C1 + C2 + C3} \delta V_{BL1a}$$

due to the potential rise of the bit line BL1a via the static capacitance of 1/2 C1 between the bit lines BL1a and $\overline{BL1a}$ at the top half TH. At the bottom half BH, the potential of the bit line $\overline{BL1a}$ is also raised by the same amount as above due to the potential rise of the bit line BL1a via the static capacitance of 1/2 C1 between the bit lines BL1a and $\overline{BL1a}$ at the bottom half BH. The second member on the right in equation (6) shows the effect of the potential rise of the bit line BL2a on the bit line $\overline{BL1a}$ via the static capacitance of 1/2 C2 at the bottom half. Note that the potential of the bit line $\overline{BL0a}$ does not rise when the word line WL0 is selected, because the memory cells connected to the bit line $\overline{BL0a}$ are not connected to the selected word dine WL0. Therefore, the capacitance between the bit lines $\overline{BL0a}$ and the BL1a at the illustrated bottom half BH does not influence the potential of the bit line $\overline{BL1a}$. Therefore, from equations (5) and (6), the potential difference $\Delta V_{BL1a}$ between the bit lines BL1a and $\overline{BL1a}$ is:

$$\Delta V_{BL1a} \simeq \delta V_{BL1a} - \delta V_{\overline{BL1a}}$$

$$= \delta V_{BL1} - \frac{C_1}{C_1 + C_2 + C_3} \delta V_{BL1a} \qquad (7)$$

In equation (7), if the approximation that C1 = C2 = C3 and $\delta V_{BL1a} = \delta V_{BL1}$ is made, then,

$$\Delta V_{BL1a} \simeq \frac{2}{3} \delta V_{BL1} \qquad (8)$$

Therefore, compared with the prior art expressed in equation (4), the effect of the potential rise of the bit line BL2a on the potential difference $\Delta V_{BL1a}$ is cancelled out, thus enabling prevention of a considerable amount of potential drop between the bit lines BL1a and $\overline{BL1a}$.

Similarly, the potential difference between the bit lines BL2a and $\overline{BL2a}$ can be calculated as:

$$\delta V_{BL2a} \simeq \delta V_{BL2} + \frac{1/2\ C_2}{C_1 + C_2 + C_3} \delta V_{BL1a} \qquad (9)$$

$$\delta V_{\overline{BL2a}} \simeq \frac{C_1}{C_1 + C_2 + C_3} \delta V_{BL2a}$$

$$+ \frac{1/2\ C_1}{C_1 + C_2 + C_3} \delta V_{BL3a} \qquad (10)$$

$$\Delta V_{BL2a} \simeq \delta V_{BL2a} - \delta V_{\overline{BL2a}}$$

$$= \delta V_{BL2} + \frac{1/2\ C_2}{C_1 + C_2 + C_3} \delta V_{BL1a}$$

$$- \frac{C_1}{C_1 + C_2 + C_3} \delta V_{BL2a} - \frac{1/2\ C_1}{C_1 + C_2 + C_3} \delta V_{BL3a}$$

$$(11)$$

Assume that C1 = C2 = C3 and $\delta V_{BL1a} = \delta V_{BL2a} = \delta V_{BL3a} = \delta V_{BL2}$ , then

$$\Delta V_{BL2a} \simeq \delta V_{BL2} - \frac{1}{3}\ \delta V_{BL2a}$$
$$= \frac{2}{3}\ \delta V_{BL2} \qquad (12)$$

Equation (12) has the same result as equation (8).

The above description was made for the case where the word line WL0 is selected. A similar discussion also applies when the word line WL1 or the other word lines are selected.

In the above description of the embodiment, especially for the calculation of the potential difference between the bit lines BL1a and $\overline{BL1a}$, the explanation was simplified by ignoring the effects on the potential of the bit line BL2a by the potential rise of the adjacent bit line $\overline{BL1a}$ at the illustrated top half and the effects by the potential rise of the adjacent bit line BL1a at the illustrated bottom half. However, computer simulation suggests that even if these are considered, a similar advantageous effect as described above would be obtained. Further, even if consideration is given to the effects on the bit Lines BL1a, $\overline{BL1a}$ by bit lines other than adjacent bit lines, the advantageous effect obtained by the present invention is guaranteed.

In equation (11), however, if the above-mentioned assumption $\delta V_{BL1a} = \delta V_{BL2a} = \delta V_{BL3a}$ does not stand, for example, if the potential rise $\delta V_{BL3b}$ of the bit line BL3b is greater than the potential rise $\delta V_{BL1b}$ of the bit line BL1b for some reason, for example, if no charge was stored in the memory cell MC1 connected between the word line WL0 and the bit line BL1a, the potential difference $\Delta V_{BL2a}$ will be decreased to be smaller than that expressed in equation (12).

Other embodiments which can solve this problem in the circuit of Fig. 6 are explained below.

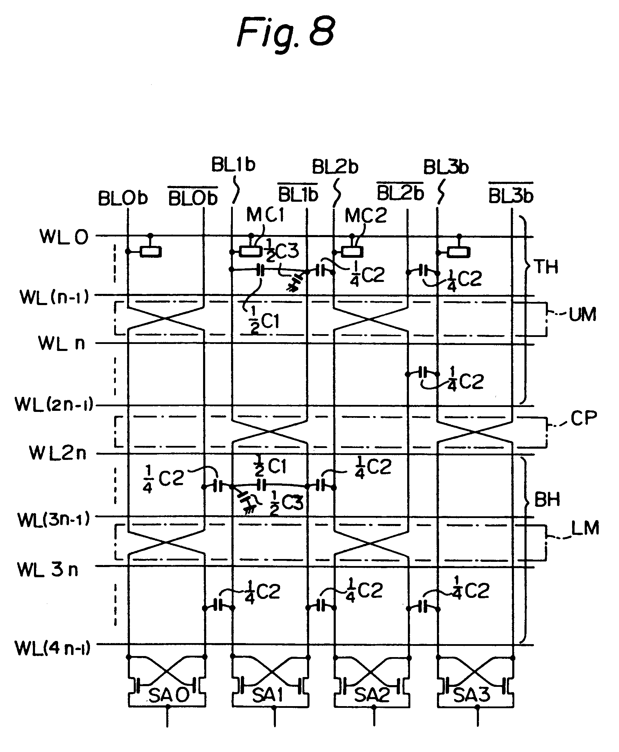

Figure 8 is a circuit diagram showing the arrangement of bit line pairs in a one-transistor one-capacitor dynamic memory according to another embodiment of the present invention. Figure 8 differs from Fig. 6 in that the lines of the bit line pairs (BL0b, $\overline{BL0b}$), (BL2b, $\overline{BL2b}$), ... are in Fig. 8 intersected at an upper midway portion UM in the top half TH and at a lower midway portion LM in the bottom half BH. In the illustrated embodiment, the upper midway portion UM is positioned one-fourth of the bit line down from the top, and the lower midway LM is positioned one-fourth of the bit line up from the bottom. The other portions are the same as in Fig. 6. By this construction, the potential difference between, for example, bit line pair BL1b and $\overline{BL1b}$, when the word line WL0 is selected, is calculated as follows:

$$\delta V_{BL1b} \simeq \delta V_{BL1} + \frac{1/4\ C_2}{C_1 + C_2 + C_3}\ \delta V_{BL2b} \qquad (13)$$

$$\delta V_{\overline{BL1b}} \simeq \frac{C_1}{C_1 + C_2 + C_3}\ \delta V_{BL1b}$$

$$+ \frac{1/4\ C_2}{C_1 + C_2 + C_3}\ \delta V_{BL2b}$$

$$+ \frac{1/4\ C_2}{C_1 + C_2 + C_3}\ \delta V_{BL0b} \qquad (14)$$

$$\Delta V_{BL1b} \simeq \delta V_{BL1b} - \delta V_{\overline{BL1b}}$$

$$= \delta V_{BL1} - \frac{C_1}{C_1 + C_2 + C_3}\ (\delta V_{BL1b} + \frac{1}{4}\frac{C_2}{C_1}\delta V_{BL0b})$$

$$(15)$$

In equation (13), $\delta V_{BL1b}$ on the left indicates the potential rise of the bit line BL1b, the first member $\delta V_{BL1}$ on the right indicates the potential rise component of the bit line BL1b due to the influx of the charge from the memory cell MC1 to the bit line BL1b, and the second member on the right indicates the potential rise component of the bit line due to the potential rise of the bit line BL2b adjacent at the lower half of the bottom half BH via the static capacitance 1/2 C2. In equation (14), $\delta V_{\overline{BL1b}}$ on the left indicates the potential rise of the bit line $\overline{BL1b}$, the first member one right indicates the potential rise component of the bit line $\overline{BL1b}$ due to the potential rise of the bit line BL1b via the static capacitances 1/2 C1 at the top half and 1/2 C1 at the bottom half, the second member on the right indicates the potential rise component of the bit line $\overline{BL1b}$ due to the potential rise of the bit line BL2b adjacent at the upper half of the top half TH via the static capacitance of 1/4 C2, and the third member on the right indicates the potential rise component of the bit line $\overline{BL1b}$ due to the potential rise of the bit line BL0b adjacent at the upper half of the bottom half BH via the static capacitance of 1/4 C2.

In the potential difference between the potential rises of BL1b and $\overline{BL1b}$, the components derived from the potential rise of the bit line BL2a are also cancelled, as can be seen from equation (15). In equation (15), if the approximation that C1 = C2 = C3 and $\delta V_{BL1}$ = $wV_{BL1b}$ = $\delta V_{BL0b}$ is also made in the same way as in equation (6), then

$$\Delta V_{BL1b} = \tfrac{7}{12}\delta V_{BL1} \qquad (16)$$

The potential difference $\Delta V_{BL1b}$ expressed by equation (13) is also greater than the conventional potential difference expressed by equation (4).

The potential difference between the bit lines, for example, BL2b and $\overline{BL2b}$, is calculated as follows:

$$\delta V_{BL2b} \simeq \delta V_{BL2} + \frac{1/4\ C_2}{C_1 + C_2 + C_3}\ \delta V_{BL3b}$$

$$+ \frac{1/4\ C_2}{C_1 + C_2 + C_3}\ \delta V_{BL1b} \qquad (17)$$

$$\delta V_{\overline{BL2b}} = \frac{1/4\ C_2}{C_1 + C_2 + C_3}\ \delta V_{BL3b}$$

$$+ \frac{1/4\ C_2}{C_1 + C_2 + C_3}\ \delta V_{BL1b}$$

$$+ \frac{1/4\ C_2}{C_1 + C_2 + C_3}\ \delta V_{BL3b} \qquad (18)$$

$$\Delta V_{BL2b} = \delta V_{BL2b} - \delta V_{\overline{BL2b}}$$

$$= \delta V_{BL2} - \frac{1/4\ C_2}{C_1 + C_2 + C_3}\ \delta V_{BL3b} \qquad (19)$$

In equation (17), the first member is derived due to the influx of the charge from the memory cell MC2 to the bit lines BL2b; the second member on the right indicates the potential rise of the bit line BL2b due to the potential rise of the bit line BL3b at the lower half portion in the illustrated top half TH via the capacitance of 1/4 C2, because the bit line BL2b is adjacent to the bit line BL3b at that lower half portion; and the third member on the right indicates the effect of the potential rise of the bit line BL1b on the bit line BL2b at the lower half portion in the bottom half BH via the capacitance of 1/4 C2, because the bit line BL2b is adjacent to the bit line BL1b at the lower half portion in the bottom half BH. Similarly, in equation (18), the first member indicates the effect of the potential rise of the bit line BL3b at the lower half portion in the top half TH; the second member indicates the effect of the potential rise of the bit line BL1b at the upper half portion in the bottom half BH; and the third member indicates the effect of the potential rise of the bit line BL3b at the lower half portion in the bottom half BH.

As will be seen from equation (19), the effects of the potential rise of the bit lines BL1b and BL3b in equation (17) are cancelled so that only the factor

$$\frac{1/4\ C2}{C1 + C2 + C3}\ \delta V_{BL3b}$$

remains in equation (19). This factor is much smaller even when the potential rise $\delta V_{BL3b}$ is large.

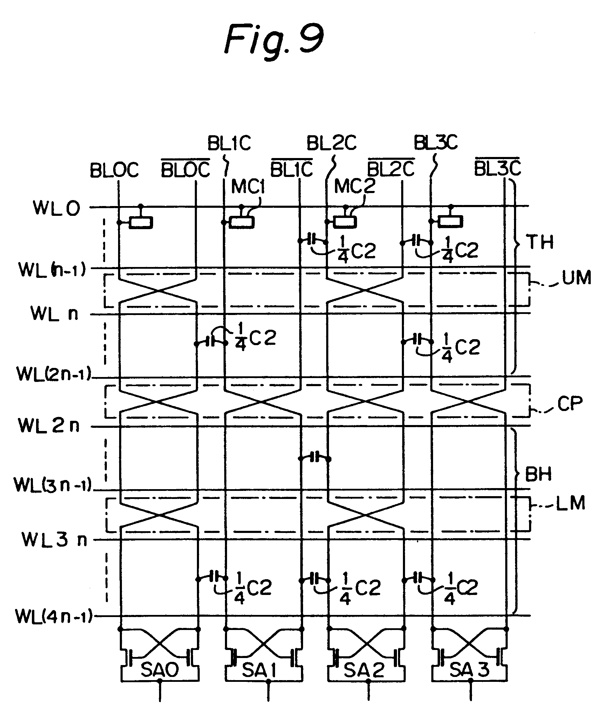

Figure 9 shows a still further embodiment of the present invention. The difference between Fig. 8 and Fig. 9 is that, in Fig. 9, the lines of each of the bit line pairs (BL0b, $\overline{BL0b}$), (BL1b, $\overline{BL1b}$), (BL2b, $\overline{BL2b}$), ... are intersected at the center portion CP.

By this construction, the potential difference between, for example, bit lines BL1b and $\overline{BL1c}$ is calculated as follows:

$$\delta V_{BL1c} \simeq \delta V_{BL1} + \frac{1/4\ C_2}{C_1 + C_2 + C_3}\ \delta V_{BL0c}$$

$$+ \frac{1/4\ C_2}{C_1 + C_2 + C_3}\ \delta V_{BL2c} \qquad\qquad (20)$$

$$\delta V_{\overline{BL1c}} \simeq \frac{C_1}{C_1 + C_2 + C_3}\ \delta V_{BL1c}$$

$$+ \frac{1/4\ C_2}{C_1 + C_2 + C_3}\ \delta V_{BL2c}$$

$$+ \frac{1/4\ C_2}{C_1 + C_2 + C_3}\ \delta V_{BL0c} \qquad\qquad (21)$$

$$\Delta V_{BL1c} = \delta V_{BL1} - \frac{C_1}{C_1 + C_2 + C_3}\ \delta V_{BL1c} \qquad\qquad (22)$$

Similarly, the potential difference between, for example, bit lines BL2c and $\overline{BL2c}$ is calculated as follows

$$\delta V_{BL2c} \simeq \delta V_{BL2} + \frac{1/4\ C_2}{C_1 + C_2 + C_3}\ \delta V_{BL3c}$$

$$+ \frac{1/4\ C_2 \cdot}{C_1 + C_2 + C_3}\ \delta V_{BL1c} \qquad\qquad (23)$$

$$\delta V_{\overline{BL2c}} \simeq \frac{C_1}{C_1 + C_2 + C_3}\ \delta V_{BL2c}$$

$$+ \frac{1/4\ C_2}{C_1 + C_2 + C_3}\ \delta V_{BL3c}$$

$$+ \frac{1/4\ C_2}{C_1 + C_2 + C_3}\ \delta V_{BL1c} \qquad\qquad (24)$$

$$\Delta V_{BL2c} \simeq \delta V_{BL2} - \frac{C_1}{C_1 + C_2 + C_3}\ \delta V_{BL2c} \qquad\qquad (25)$$

Thus, in the embodiment shown in Fig. 9, the effects of the potential rises of the adjacent bit line pairs are cancelled, as can be seen from equations (22) and (25).

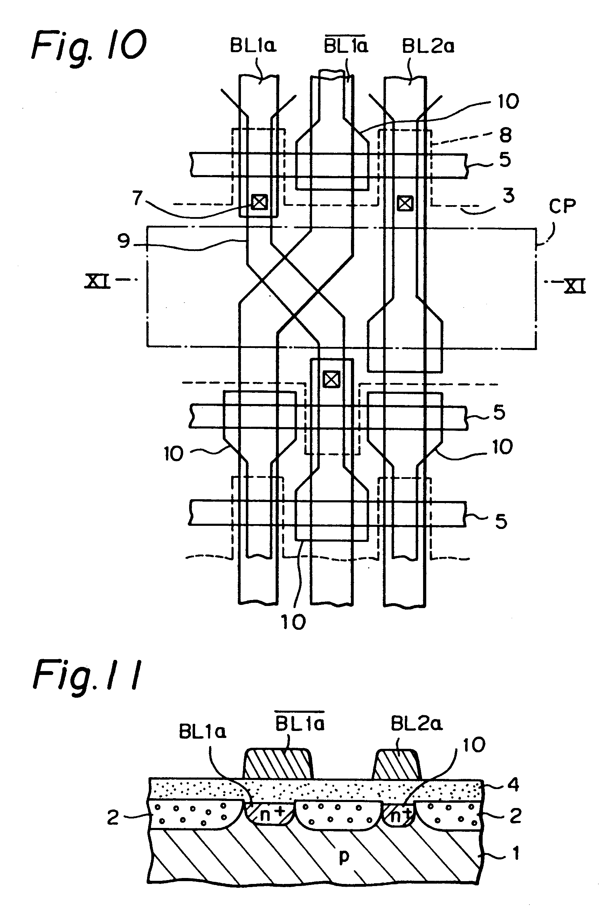

At the intersection portion of each two bit lines, one bit line can be formed by the aluminum layer of the bit line itself, and the other bit line can be made by an impurity diffused layer. The physical structure of the intersection portion is illustrated as an example in Figs. 10 and 11.

Figure 10 is a plan view of the physical construction of part of the circuit of Fig. 6, and Fig. 11 is a cross-sectional view taken along line XI-XI of Fig. 10. In Fig. 10, the bit lines BL1a and $\overline{BL1a}$ intersect each other at the central portion of these bit lines. At the intersection portion, the bit line BL1a is formed by an $n^+$-type impurity diffused layer 9 which is connected to an active region 10 at one end and is connected through a contact hole 7 to the aluminum layer of the bit line BL1a. The bit line $\overline{BL1a}$ is formed by the aluminum layer. Reference numerals in Figs. 10 and 11 the same as in Fig. 5 represent the same portions as in Fig. 5.

From the foregoing description, it will be apparent that, according to the present invention, in a semiconductor memory device having a plurality of bit line pairs, intersecting the bit lines in bit line pairs at appropriate portions can reduce the voltage drop between the bit lines in the bit line pairs arising from the electrostatic capacitance between them, so that read errors can be prevented.

**Claims**

1.  A semiconductor memory device comprising:-
    a plurality of word lines (WL0, WL1, ...);
    a plurality of bit line pairs (BL0, $\overline{BL0}$; BL1, $\overline{BL1}$; ...), each comprised of two adjacently arranged bit lines;
    a plurality of memory cells (MC0, MC1, ...) connected between the word lines and bit lines; and
    a plurality of sense circuits (SA0, SA1, ...), each connected to one of said bit line pairs;
    wherein the bit lines of at least every other pair (BL1, $\overline{BL1}$; BL3, $\overline{BL3}$; ...) of said bit line pairs are made to intersect at at least one portion thereof;
    characterised in that:-
    the device is a dynamic semiconductor memory device in which the memory cells are one-transistor one-capacitor type memory cells each connected between one of said bit lines and one of said word lines, and in each of said bit line pairs, the memory cells are connected between each one of said word lines and either one of the two bit lines of each bit line pair; wherein said sense circuits are in the form of sense amplifiers, each of said sense amplifiers amplifying the voltage difference between the bit lines of the corresponding bit line pair to which it is connected; and wherein in a precharging operation, each of the bit line pairs is precharged at a voltage which is an intermediate level relative to a power source voltage level, and in a sensing operation, the capacitor of the memory cell selected by the word line is connected, via the transistor, to one of the two bit lines which comprises the bit line pair, and after the output of the selected memory cell has appeared on said one of the bit lines, the difference voltage between said bit line and the other bit line is amplified by the corresponding sense amplifier.

2.  A semiconductor memory device as set forth in claim 1, wherein only the bit lines of every other bit line pair (BL1, $\overline{BL1}$; BL3, $\overline{BL3}$; ...) are made to intersect.

3.  A semiconductor memory device as set forth in claim 2, wherein the bit lines of every other bit line pair (BL1, $\overline{BL1}$; BL3, $\overline{BL3}$; ...) are made to intersect at only one portion thereof.

4.  A semiconductor memory device as set forth in claim 1, 2 or 3, wherein said bit line pairs (BL0, $\overline{BL0}$; BL1, $\overline{BL1}$; ...) extend in parallel with each other except for said intersection portions.

5.  A semiconductor memory device as set forth in claim 1, 2, 3 or 4, wherein said portions are central portions in the direction in which said bit line pairs (BL0, $\overline{BL0}$; BL1, $\overline{BL1}$; ...) extend.

6.  A semiconductor memory device as set forth in claim 1, wherein the bit lines of every other bit line pair (BL1, $\overline{BL1}$; BL3, $\overline{BL3}$; ...) are made to intersect at central portions in the direction in which said bit line pairs extend and the bit lines of the remaining bit line pairs (BL0, $\overline{BL0}$; BL2, $\overline{BL2}$; ...) are made to intersect at other portions.

7.  A semiconductor memory device as set forth in claim 6, wherein said other portions are both in a top and a bottom half of said bit line pairs (BL0, $\overline{BL0}$; BL2, $\overline{BL2}$; ...).

8.  A semiconductor memory device as set forth in claim 7, wherein the bit lines of said remaining bit line pairs (BL0, $\overline{BL0}$; BL2, $\overline{BL2}$; ...) are also made to intersect at said central portions.

EP 0 167 281 B1

**Patentansprüche**

1. Halbleiterspeicheranordnung, mit:
   einer Vielzahl von Wortleitungen (WL0, WL1, ...);
   einer Vielzahl von Bitleitungspaaren (BL0, $\overline{BL0}$; BL1, $\overline{BL1}$; ...), die jeweils aus zwei benachbart angeordneten Bitleitungen bestehen;
   einer Vielzahl von Speicherzellen (MC0, MC1, ...), die zwischen den Wortleitungen und den Bitleitungen angeschlossen sind; und
   einer Vielzahl von Leseschaltungen (SA0, SA1, ...), die jeweils mit einem der genannten Bitleitungspaare verbunden sind;
   bei welcher die Bitleitungen zumindest jedes zweiten Paares (BL1, $\overline{BL1}$; BL3, $\overline{BL3}$; ...) der genannten Bitleitungspaare angeordnet sind, einander an zumindest einem Abschnitt hiervon zu kreuzen;
   dadurch gekennzeichnet, daß:
   die Anordnung eine dynamische Halbleiterspeicheranordnung ist, bei welcher die Speicherzellen Speicherzellen vom Ein-Transistor-Ein-Kondensator-Typ sind, die jeweils zwischen einer der genannten Bitleitungen und einer der genannten Wortleitungen angeschlossen sind, und in jedem der genannten Bitleitungspaare die Speicherzellen zwischen jeder der genannten Wortleitungen und einer der beiden Bitleitungen jedes Bitleitungspaares angeschlossen sind; bei welcher die genannten Leseschaltungen in Form von Leseverstärkern vorliegen, wobei jeder der genannten Leseverstärker den Spannungsunterschied zwischen den Bitleitungen des entsprechenden Bitleitungspaares, mit dem er verbunden ist, verstärkt; und bei welcher in einem Vorladebetrieb jedes der Bitleitungspaare mit einer Spannung vorgeladen wird, die ein Zwischenpegel relativ zu einem Energiequellen-Spannungspegel ist, und in einem Lesebetrieb der Kondensator der von der Wortleitung ausgewählten Speicherzelle über den Transistor mit einer der beiden Bitleitungen verbunden ist, die das Bitleitungspaar bilden, und, nachdem der Ausgang der ausgewählten Speicherzelle an der genannten einen der Bitleitungen erschienen ist, der Spannungsunterschied zwischen der genannten Bitleitung und der anderen Bitleitung durch den entsprechenden Leseverstärker verstärkt wird.

2. Halbleiterspeicheranordnung nach Anspruch 1, bei welcher nur die Bitleitungen jedes zweiten Bitleitungspaares (BL1, $\overline{BL1}$; BL3, $\overline{BL3}$; ...) einander kreuzend angeordnet sind.

3. Halbleiterspeicheranordnung nach Anspruch 2, bei welcher die Bitleitungen jedes zweiten Bitleitungspaares (BL1, $\overline{BL1}$; BL3, $\overline{BL3}$; ...) angeordnet sind, einander nur an einem Abschnitt hiervon zu kreuzen.

4. Halbleiterspeicheranordnung nach Anspruch 1, 2 oder 3, bei welcher die genannten Bitleitungspaare (BL0, $\overline{BL0}$; BL1, $\overline{BL1}$; ...) parallel zueinander verlaufen, mit Ausnahme der genannten Kreuzungsabschnitte.

5. Kalbleiterspeicheranordnung nach Anspruch 1, 2, 3 oder 4, bei welcher die genannten Abschnitte zentrale Abschnitte in der Richtung sind, in die die genannten Bitleitungspaare (BL0, $\overline{BL0}$; BL1, $\overline{BL1}$; ...) verlaufen.

6. Halbleiterspeicheranordnung nach Anspruch 1, bei welcher die Bitleitungen jedes zweiten Bitleitungspaares (BL1, $\overline{BL1}$; BL3, $\overline{BL3}$; ...) angeordnet sind, einander an zentralen Abschnitten in der Richtung zu kreuzen, in die die genannten Bitleitungspaare verlaufen, und die Bitleitungen der übrigen Bitleitungspaare (BL0, $\overline{BL0}$; BL2, $\overline{BL2}$; ...) angeordnet sind, einander an anderen Abschnitten zu kreuzen.

7. Halbleiterspeicheranordnung nach Anspruch 6, bei welcher die genannten anderen Abschnitte sowohl in einer oberen als auch einer unteren Hälfte der genannten Bitleitungspaare (BL0, $\overline{BL0}$; BL2, $\overline{BL2}$; ...) vorliegen.

8. Halbleiterspeicheranordnung nach Anspruch 7, bei welcher die Bitleitungen der genannten übrigen Bitleitungspaare (BL0, $\overline{BL0}$; BL2, $\overline{BL2}$; ...) ebenfalls angeordnet sind, einander an zentralen Abschnitten zu kreuzen.

**Revendications**

11

1. Dispositif de mémoire à semiconducteur comprenant:

une pluralité de fils de mot (WL0,WL1,...);

une pluralité de paires de fils de bit (BL0,$\overline{BL0}$; BL1,$\overline{BL1}$;...), constituées chacune de deux fils de bit disposés l'un à côté de l'autre;

une pluralité de cellules de mémoire (MC0,MC1,...) connectées entre les fils de mot et les fils de bit; et

une pluralité de circuits de détection (SA0,SA1, ...), connectés chacun à une desdites paires de fils de bit;

dans lequel les fils de bit d'au moins chaque autre paire (BL1,$\overline{BL1}$; BL3,$\overline{BL3}$;...) desdites paires de fils de bit sont réalisés pour se couper au moins dans une partie de ceux-ci;

caractérisé en ce que:

le dispositif est un dispositif de mémoire à semi-conducteur dynamique dans lequel les cellules de mémoire sont des cellules de mémoire du type à un transistor et un condensateur connectées chacune entre un desdits fils de bit et un desdits fils de mot, et dans chacune desdites paires de fils de bit, les cellules de mémoire sont connectées entre chacun desdits fils de mot et l'un des deux fils de bit de chaque paire de fils de bit; dans lequel lesdits circuits de détection sont sous la forme d'amplificateurs de détection , chacun desdits amplificateurs de détection amplifiant la différence de tension entre les fils de bit de la paire de fils de bit correspondante à laquelle il est connecté; et dans lequel dans une opération de précharge, chacune des paires de fils de bit est préchargée à une tension qui a un niveau intermédiaire par rapport à un niveau de tension de source d'alimentation, et dans une opération de détection, le condensateur de la cellule de mémoire sélectionnée par le fil de mot est connecté , par l'intermédiaire du transistor, à un des deux fils de bit qui constituent la paire de fils de bit, et après que le signal de sortie de la cellule de mémoire sélectionnée soit apparu sur ledit des fils de bit, la différence de tension entre ledit fil de bit et l'autre fil de bit est amplifiée par l'amplificateur de détection correspondant.

2. Dispositif de mémoire à semiconducteur selon la revendication 1, dans lequel seuls les fils de bit de chaque autre paire de fils de bit (BL1,$\overline{BL1}$;BL3,$\overline{BL3}$;...) sont faits pour se couper.

3. Dispositif de mémoire à semiconducteur selon la revendication 2, dans lequel les fils de bit de chaque autre paire de fils de bit (BL1,$\overline{BL1}$;BL3,$\overline{BL3}$;...) sont faits pour se couper uniquement dans une partie de ceux-ci.

4. Dispositif de mémoire à semiconducteur selon l'une quelconque des revendications 1 à 3, dans lequel lesdites paires de fils de bit (BL0,$\overline{BL0}$;BL1,$\overline{BL1}$;...) s'étendent en parallèle entre elles à l'exception des parties d'intersection.

5. Dispositif de mémoire à semiconducteur selon l'une quelconque des revendications 1 à 4, dans lequel lesdites parties sont des parties centrales dans la direction où s'étendent lesdites paires de fils de bit (BL0,$\overline{BL0}$;BL1,$\overline{BL1}$;...).

6. Dispositif de mémoire à semiconducteur selon la revendication 1, dans lequel les fils de bit de chaque autre paire de fils de bit (BL1,$\overline{BL1}$;BL3,$\overline{BL3}$;...) sont réalisés pour se couper dans des parties centrales dans la direction où s'étendent lesdites paires de fils de bit et les fils de bit des autres paires de fils de bit (BL0,$\overline{BL0}$;BL2,$\overline{BL2}$;...) sont réalisés pour se couper dans d'autres parties.

7. Dispositif de mémoire à semiconducteur selon la revendication 6, dans lequel lesdites autres parties sont à la fois dans une moitié supérieure et dans une moitié inférieure desdites paires de fils de bit (BL0,$\overline{BL0}$;BL2,$\overline{BL2}$;...).

8. Dispositif de mémoire à semiconducteur selon la revendication 7, dans lequel les fils de bit desdites autres paires de fils de bit (BL0,$\overline{BL0}$;BL2,$\overline{BL2}$;...) sont également réalisés pour se couper dans lesdites parties centrales.

*Fig. 1*

*Fig. 2A*

*Fig. 2B*

## Fig. 3 A

## Fig. 3 B

## Fig. 4

6(BL0)    6($\overline{BL0}$)    6(BL1)

10

8

5(WL0)

7

9

3

5(WL1)

8

10

10

8

5(WL2)

7

5(WL3)

10

10

5(WL4)

## Fig. 5

C3   6   C1   7   6   C2   6   C3   4

4

3

2

1

4

3

2

10

Fig. 6

## Fig. 7A

## Fig. 7B

# Fig. 8

# Fig. 9

EP 0 167 281 B1

## Fig. 10

## Fig. 11

20